# EUROPEAN PATENT APPLICATION

(11) **EP 2 560 017 A2**
(43) Date of publication of application: **20.02.2013**
(21) Application number: 12179618.9
(22) Date of filing: 08.08.2012
(51) Int. Cl.: G01R 33/34

(54) **MRT local coil apparatus for diagnostics, intervention and therapy**

(30) Priority: 26.10.2011 DE 102011054832; 22.06.2012 DE 102012105451; 18.08.2011 EP 11177908
(71) Applicant: Lumiani, Agron, 33617 Bielefeld (DE)
(72) Inventor: Lumiani, Agron, 33617 Bielefeld (DE)
(74) Representative: Wittmann, Günther

(57) **Abstract**

The invention discloses an MRT local coil apparatus (1), comprising
― at least one carrier (T1, T2); and
― at least one antenna element (K11 ― K202) adapted for transmitting and/or receiving of MRT signals;

wherein the at least one antenna element (K11 ― K202) is arranged in the carrier (T1, T2);
wherein the carrier (T1) comprises at least one intervention opening (2) adapted to provide an access for a medical instrument to the patient. The MRT local coil apparatus (1) may be converted in a diagnosis local coil apparatus or an intervention local coil apparatus and vise versa by moving the first carrier portion (T1) with antenna elements (K11 ― K23) with respect to the second carrier portion (T2) with antenna elements (K100 ― K202). The invention also discloses an MRT perineal local coil apparatus (200) arranging at least one antenna element (218, 220, 222) in the perineal portion of a patient.

## Description

The invention relates to a MRT local coil apparatus (RF coil apparatus) for diagnostics, intervention and therapy.

A magnet resonance system comprises a magnet generating a static magnetic field along the patient in a longitudinal direction. A gradient coil causes that the static magnetic field changes its value along the longitudinal direction. The resonance frequency of the hydrogen atoms depends on the value of the static magnetic field. By a so-called bird cage antenna the spin of the hydrogen nuclei may be excited. Due to the static magnetic field changing its value along the patient axis the hydrogen nuclei comprise different resonance frequencies (Larmor frequency) at different locations. The relaxation of the hydrogen nuclei after the excitation may be determined by a local coil apparatus arranged at a patient. Thereby, the density of the tissue and the conglomeration, respectively of hydrogen nuclei in a patient may be determined and used for imaging. For obtaining high quality images the local coil apparatus is to be located as close as possible to the part of the body to be examined.

The operation of a magnetic resonance system is known by the person skilled in the art and described, inter alia, in Imaging Systems for Medical Diagnostics, Arnulf Oppelt, Publicis Corporate Publishing, ISBN 3-89578-226-2.

MRT local coil apparatus comprise antenna elements as receiving coils. By these antenna elements RF signals from the examined body area are received after excitation. The MRT local coil apparatus may be a so-called local coil. Different approaches exist for bringing the RF signal as close as possible to the body area to be examined for achieving a good signal power and accordingly good and appropriate diagnostic findings.

On the one hand antenna elements may be located in a rigid carrier of a local coil apparatus arranged in an examination table. Alternatively or additionally the local coil elements may be integrated into the examination table. The local coil apparatus may be used for examining the lumbar spine and the thoracic spine as well as examinations of the whole body. For examining the prostate in the prior art the patient is lying on his back. The above mentioned local coil apparatus is located at the back of the patient.

Further, cylindrical non-adapted rigid local coil apparatus are known (such as a head coil, knee coil). Also flexible local coil apparatus are known that are adapted to the body area. For example coil apparatus having the form of a cuff are known that are flexible enough such that they may be applied around the body area to be examined (such as shoulder coils, wrist coils, abdomen coils or pelvic coils). The local coils may also emit excitation signals.

The MRT method is used in diagnostics for obtaining diagnostic findings. For examining the prostate an abdomen local coil apparatus, a spinal local coil apparatus and an endorectal local coil are used for MRT systems having a static magnetic field with an intensity of up to approximately 1.5 T. The endorectal local coil is secured in the large intestine of the patient by air. Air causes undesired artifacts in an MRT image, particularly in highly sensitive sequences (EPI-diffusion sequence). Therefore, for MRT systems having a static magnetic field of approximately 3 T or more no endorectal local coils are used, since otherwise additional artifacts will occur.

On the other hand, there are MRT based therapeutic and diagnostic methods in which before the treatment repeatedly MRT images are made to monitor the exact progress of the corresponding treatment (for example MRT controlled HIFU therapy of the prostate).

A further example is the MRT based rectal biopsy through the large intestine for diagnosis of the prostate carcinoma. This method has the risk that bacteria from the large intestine may get into the prostate. A further disadvantage of such method is that it is automatically performed under computer control. Therefore, the biopsy is not under control of the physician reducing the accuracy of the biopsy if the patient moves. Further, in this method no local anesthesia is possible.

DE 102 21 644 A1 relates to a MRT perineal local coil apparatus.

US 2007/0016003 A1 relates to a magnetic resonance system, particularly to a local coil apparatus for the chest having an open architecture, in which parts of the human body are accessible which are imaged.

US 2011/0169491 A1 relates to a spinal coil apparatus, wherein the density of the coil elements in a first region differs from the density in a second region.

US 2005/0080333 A1 discloses an MR based biopsy, wherein the exact positioning of the needle is supported by ultrasonic imaging. The method disclosed therein may be used in the abdominal region, the back, the liver, the kidney, the chest and the brain.

It is an object of the present invention to provide an MRT local coil apparatus by which the field of application of the corresponding MRT coil apparatus is increased.

The object of the invention is solved by a MRT local coil apparatus having the features of claim 1. Advantageous embodiments may be found in the depending claims.

The MRT local coil apparatus (RF coil) comprises a carrier and at least one antenna element each adapted for receiving MRT signals and/or emitting excitation signals. The at least one antenna element is arranged in the carrier. The carrier comprises at least one intervention opening adapted to provide an access for a medical instruments to the patient. The medical instrument may be guided through the intervention opening to the patient. Preferably, the at least one antenna element is located in close neighborhood to the intervention opening such that receiving of MRT signals may be performed close to and above, respectively of the organ to be examined (such as the prostate) of the patient. At the same time in the area of the intervention opening an access for puncturing, intervention or minimal invasive therapy is provided. Thereby, MRT images may be generated to locate an instrument - such as a needle tip of a puncturing cannula - relative to a lesion and to accomplish a tissue removal from the lesion and from an organ, respectively. Thereby, the duration of treatment may be reduced significantly. Also other MRT based interventions and minimal invasive therapies may be performed and controlled. Accordingly, by the invention a multifunctional local coil apparatus for different applications, such as for the field of diagnostics, the field of intervention and the field of therapy, is provided.

The expression intervention opening is to interpreted such that it provides access to the human or animal body for diagnostics and/or therapy. The intervention opening may be also termed as a instrument access opening. The intervention opening may serve for preparing an operation.

The MRT local coil apparatus may be adapted to be positioned at the patient such that the at least one intervention opening is located in the body longitudinal direction (direction from head to feet), i.e. cranio-caudal direction, of the patient approximately at the same position as the prostate and the pelvis minor (lesser pelvis), respectively, and that a rectangle circumscribing the at least one intervention opening is located dorsal above the prostate and the pelvis minor, respectively. The at least one intervention opening may be arranged at the site of the natal cleft (cerena analis). The intervention opening and the at least one rectangle circumscribing the intervention opening may be arranged in cranio-caudal direction at the position of the prostate of the patient dorsal (rear side of the pelvis) over the pelvis minor.

The antenna elements may be formed as coil elements. In practice, the antenna elements are also termed channels. Each channel may be assigned to at least one antenna element.

A higher number of antenna elements may be arranged in an area close to and above, respectively a organ to be diagnosed. In a local coil apparatus for diagnosis of the prostate a higher number of antenna elements may be arranged in an area close to and, respectively above the middle of the pelvis minor. Further, a higher number of antenna elements may be arranged at the pelvis major (greater pelvis), particularly at the rim (i.e. lateral wall) of the pelvis major to detect potential lymph node metastases and bone metastases. The antenna elements may be arranged within the local coil apparatus non-uniform, for example not equidistant. The applicant reserves the right to claim this subject matter in a separate application, such as in a divisional application.

The carrier may be configured as a cuff that may be opened and closed.

The MRT local coil apparatus according to the present invention is particularly suited for MRT based biopsy of small lesions of an organ or a region having a size of millimeters, for difficult access ways, for difficult procedures and preparation of the same (such as prostate without rectal access). Therefore, the invention comprises advantageously a frame limiting the window like intervention opening. Preferably, this frame is formed such that it comprises a plurality of functions. On the one hand it serves as a socket for a reference element. This reference element is inserted in order to determine the position of a finding or lesion relative to the surface. Preferably, the reference element is a grid of tubes in which a fluid appropriately visible in an MRT image is encapsulated, such as fish oil. The reference element may comprise first alignment means, such as a grid.

In one embodiment the border of the frame(s) may be filled with a material visible in an MRT image. The position of the frame may be monitored during imaging in order to compensate movements of the body of the patient. Thus, the frame(s) may be used as a tracker.

At at least two adjacent sides of the frame inclined sliding surfaces are provided, wherein the sliding surfaces are inclined in the same direction with respect to an access perpendicular to the intervention opening. The sliding surfaces are provided such that the reference element, which comprises a shape corresponding essentially to the shape of the intervention opening, preferably a rectangular shape, presses against one edge of the intervention opening such that the reference point cannot move during measurements. By measuring the position of the medical finding (lesion) with reference to the reference element the injection site on the skin surface and the injection angle for the following treatment steps may be determined for a puncturing cannula, particularly a MR compatible puncturing cannula. Since the intervention opening and the frame, respectively of the local coil apparatus is fixed during the whole treatment, the position of the injection site and the angle relatively to the intervention opening and the frame, respectively are fixed. The puncturing needle or also another instrument merely needs to be aligned in a position relatively to the intervention opening and frame, respectively for the following treatment steps or diagnostic steps.

The MRT local coil apparatus may comprise arrangement means for a medical instrument. Therefore, by MRT imaging a portion of the body may be examined and an optimal operation position for a medical instrument may be determined. Further, the medical instrument may be guided exactly to the determined optimal operation position, since the position of the MRT local coil apparatus provides an exact reference position.

According to the present invention, for the intervention procedure, such as for a biopsy, a needle holder is provided, which may be adjusted relative to the frame and the intervention opening, respectively. Therefore, the needle may be pivoted in the holder, preferably only in one plain, and may be fixed in an arbitrary angle position. Further thereto, the holder may be moved in the region of the intervention opening preferably perpendicular to the pivoting plane.

The MRT local coil apparatus may comprise cross beam arrangement means provided for arranging a cross beam over the intervention opening that may be moved at least in a first direction. Preferably, the holder is guided by a cross beam traversing the intervention opening and may be moved on the same. The frame and/or the cross beam may comprise second alignment means, such as scales (millimeter scales or inch scales, for example) to allow an exact positioning of the cross beam to the frame and of the needle holder to the cross beam. Further, these scales or marks may be used as a ruler to mark the injection site on the patient for puncturing the coordinates thereof being determined relatively to the frame or relatively to the intervention opening from the MRT image. Further thereto, it is preferably provided that the cross beam is guided moveable and fixable on the frame such that the needle tip may essentially reach each point in the region of the intervention opening. The instrument, for example a needle, is guided movably in a frame and may also be fixed in every position such that the holder acts during puncturing as a guide or support.

A slide movable in a second direction may be coupled with the cross beam. At the intervention opening, at the crossbeam and/or at the slide a medical instrument, such as a needle, may be arranged.

By means of the first alignment means on the reference element a position of the medical instrument may be determined during imaging. The position may be an (optimal) operation position of the medical instrument, such as the injection position of a needle. By means of the second alignment means on the cross beam, at the slide, at an instrument holder for a medical instrument and/or at the intervention opening the medical instrument is guided to the operation position, such as the injection position of a needle. The expression position comprises (location) coordinates in space and/or angle.

At least one antenna element may be arranged between two intervention openings.

The winding of the at least one antenna element may be formed essentially rectangular. The expression essentially rectangular is to be interpreted such that each winding may have a rounding at the edges. In one embodiment the length of the antenna element is larger than the width of the antenna element. At least one antenna element may be arranged perpendicular or parallel to the edge of the intervention opening.

The carrier may extend in the longitudinal direction further than in the cross direction. The cross direction of the carrier may correspond to the longitudinal direction (axis from head to feet) of the patient. This direction is also termed vertical direction of the patient. At least one antenna element may be located in the cross direction of the carrier next to the intervention opening and at least one antenna element may be located in the longitudinal direction of the carrier next to the intervention opening.

At least three antenna elements may be located in cross direction of the carrier next to the at least one intervention opening.

The carrier may comprise a first carrier portion adapted to be arranged on the first side of a body part of a patient, and a second carrier portion adapted to be arranged at a second side of the body part. The at least one intervention opening may be formed in the first carrier portion. Antenna elements may be formed both in the first carrier portion and the second carrier portion. The first carrier portion and the second carrier portion may be disconnected from each other. The first side and the second side may be located at opposing sites of a body part.

The first carrier portion may be arranged at a side, at which for medical reasons access for intervention of a organ is possible. The second carrier portion may be located at a side of the patient that is opposed to the first carrier portion. By this configuration an arbitrary organ may be intervened, such as the liver, the pancreas, the kidney etc.

The first carrier portion may be adapted to be arranged on the back of a patient. The second carrier portion may be adapted to be arranged on the abdomen of a patient. During imaging the patient may rest on its abdomen. This configuration may be used for intervention of the prostate.

The first carrier portion may be arranged with respect to the second carrier portion in two different positions. Thereby, the MRT local coil apparatus may be optimized on the one hand for imaging and on the other hand for the MRT based interventions.

The first carrier portion may be movable with respect to the second carrier portion such that the intervention opening may be arranged into different positions. The first carrier portion may be movable with respect to the second carrier portion such that the intervention opening may be arranged at two different positions in the cross direction of the MRT local coil apparatus and/or in the longitudinal direction of the patient.

The MRT local coil apparatus may be arranged at the pelvis of the patient, wherein the second carrier portion may be arranged on the back (dorsal) of the patient resting on its back, and the first carrier portion may be arranged at the front (ventral) of the patient. The first carrier portion may be moved such with respect to the second carrier portion that the intervention opening may be arranged at two different positions in longitudinal direction of the patient. The intervention opening may be located in the diagnosis position (or diagnostics position) in the longitudinal direction (cranio-caudal direction) over the prostate. In this case a plurality of antenna elements is located in sagittal direction or otherwise stated in dorsal direction, over the prostate. During intervention the patient rests on the abdomen, the first carrier portion is located on the back of the patient (dorsal), and the second carrier portion is located at the front (ventral) of the patient. In the intervention position of the MRT apparatus the at least one intervention opening is located in body longitudinal direction (longitudinal direction) of the patient approximately at the same height as the prostate. Accordingly, the rectangle circumscribing the at least one intervention opening is located dorsal above the prostate. In this position an intervention of the prostate, such as a puncturing, is possible.

During diagnosis (diagnostics) the patient is resting on the back, since the MRT imaging may take up to an hour. The patient must not move during such MRT imaging. This may be ensured better in supine position (dorsal position). Since in the diagnosis position of the first carrier portion more coils are arranged close to the pelvis minor, a higher resolution may be achieved as compared to the intervention position. During diagnosis a higher resolution is necessary in order to determine whether a lesion, a tumor etc. exists and where the lesion, the tumor etc. is located. During intervention a lower resolution may be sufficient since the position of the lesion, the tumor etc. is known and merely the instrument has to be guided to the lesion and tumor respectively based on the imaging.

The first carrier and/or second carrier may comprise at least one fiducial, which are adapted to be monitored by a camera during diagnosis and/or intervention. The detected positions of the at least one fiducial may be used to compensate movements of the patient during imaging.

There is also disclosed a MRT perineal local coil apparatus comprising a perineal carrier and at least one antenna element, wherein the perineal carrier is adapted to arrange the at least one antenna element in the perineal portion of a patient. The distance from the perineal portion to the prostate is compared to the ventral dorsal distance comparably short. Accordingly, particularly good MRT images are obtained, if at least one antenna element is arranged in the perineal portion.

The MRT perineal local coil apparatus may comprise a plurality of antenna elements, wherein the perineal carrier is adapted to locate a plurality of antenna elements in a direction from the front pelvis minor (symphysis, pubic bone) to the coccyx behind each other, and/or the perneal carrier is adapted to locate a plurality of antenna elements in the direction from the pelvis minor (symphysis, pubic bone) to the coccyx adjacent to each other. The plurality of antenna elements may be arranged in the crotch and genital area. Thereby, the quality of the imaging may be improved further.

The MRT perineal local coil apparatus may comprise patient securing means adapted to secure the MRT perineal local coil apparatus at the patient. By the spatial fixing of the MRT perineal local coil apparatus, the MRT perineal local coil apparatus may be prevented from moving during reception of the MRT signals.

The MRT perineal local coil apparatus may comprise first securing means and optional second securing means. The first securing means and the optional second securing means are adapted to secure the MRT perineal local coil apparatus on another MRT local coil apparatus. Also by this spatial fixing of the MRT perineal local coil apparatus, the MRT perineal local coil apparatus may be prevented from moving during reception of the MRT signals.

The MRT local coil apparatus may comprise securing means adapted to releasably secure the MRT perineal local coil apparatus on the MRT local coil apparatus. The MRT local coil apparatus may comprise third securing means arranged on the first carrier portion, and fourth securing means arranged at the second carrier portion. The third securing means may be adapted to operate in the diagnosis position with the first securing means of the MRT perineal local coil apparatus to secure the MRT perineal local coil apparatus releasably at the MRT local coil apparatus. The fourth securing means may be adapted to cooperate in the diagnosis position with the second securing means of the MRT perineal local coil apparatus to secure the MRT perineal local coil apparatus releasably at the MRT local coil apparatus. Generally, the MRT perineal local coil apparatus is merely used during diagnosis in order to achieve a particularly high quality to decide as reliably as possible whether a lesion and a tumor, respectively exists and where the lesion and the tumor, respectively is located. During the MRT based intervention the position of the lesion and the tumor, respectively is known and accordingly the MRT perineal local coil apparatus does not have to be used during MRT based intervention necessarily.

The MRT local coil apparatus and the MRT perineal local coil apparatus may be formed integral. The MRT local coil apparatus and the MRT perineal local coil apparatus may be formed by one piece. In this case the MRT local coil apparatus may be formed by a trouser.

There is also disclosed an MRT local coil set comprising the MRT perineal local coil apparatus and the MRT local coil apparatus.

There is further disclosed a medical system having a MRT local coil apparatus, the MRT perineal local coil apparatus or the MRT local coil set, a medical instrument that may be arranged over the at least one intervention opening and a magnet resonance system to which the MRT local coil apparatus is coupled. The magnet resonance system may have a static magnetic field of 1 T, 1.5 T, 3 T or 7 T.

There is also disclosed a method for converting a MRT local coil apparatus in a diagnosis local coil apparatus or an intervention local coil apparatus and vice versa, comprising the step of moving the first carrier portion with antenna elements with respect to the second carrier portion with antenna elements. If the first carrier portion is in the diagnosis position, the MRT local coil apparatus operates as diagnosis local coil apparatus. If the first carrier portion is in the intervention position, the MRT local coil apparatus operates as intervention local coil apparatus.

The method may be further configured as has been described above with respect to the apparatus.

For particular applications, such as for biopsy of the prostate, it is particularly advantagous that the MRT local coil apparatus is provided with two window like intervention openings. The corresponding MRT local coil apparatus is preferably formed by a two-part carrier, wherein one of the carrier portions consequently comprises the two intervention openings. Thereby, particularly a biopsy at the right and left side of the prostate can be accomplished, without changing or removing the local coil apparatus. Each carrier portion is preferably formed in two-row form, wherein according to the prefered embodiment herein the two intervention openings are arranged in the same row of one of the two carrier portion. Thus, particularly in prostate biopsy the lesion may be punctured sterile, safely and good without injuring vessels or organs, particularly also the large intestine. Therefore, the carrier portion comprising the intervention openings of the local coil apparatus is placed such that the natal cleft lies on a line approximately in the middle between the intervention openings or approximately in the middle of the intervention opening.

In the two row embodiment the antenna elements may be arranged for a targeted diagnosis of the pelvis such that they are located in a row in the middle portion of the pelvis minor arranged comparably densely in order to achieve a maximum resolution of the MRT signal in the region of the prostate and other organs located there. In the other row having one or more intervention opening(s) the antenna elements may comprise a larger distance, wherein at least channels and antenna elements, respectively in the immediate border area of the at least one intervention opening are to be provided. Then, at least one antenna element shall be arranged between the intervention openings. This antenna element is arranged during application directly over the prostate. A number of antenna elements is initially arbitrary, wherein at least three antenna elements are prefered, particularly also eight antenna elements in the respective second row and at least three antenna elements, particularly also five or six antenna elements in the respective first row.

Further thereto, by the two-part configuration of the local coil apparatus it is possible to rotate the part of the local coil apparatus comprising the intervention opening(s) by 180° such that a maximal appropriate resolution of the MRT signal during diagnostics on the one hand and during intervention and puncturing, respectively on the other hand may be guaranteed.

The invention is explained in the following with reference to figures 1 to 20. The figures show non limiting embodiments of the invention.
Figure 1 shows a perspective view of an MRT local coil apparatus according to the present invention having a window like intervention opening;
Figure 2 is a magnification of a part of the local coil apparatus in the region of the intervention opening;
Figures 3 shows a perspective view of the local coil apparatus in the open state;
Figure 4 shows a plan view of an reference element according to the present invention in a magnification of a portion;
Figure 5A shows a first embodiment of a local coil apparatus according to the present invention having a cross beam and needle holder in an intervention opening in a plan view;
Figure 5B shows a detailed view of the cross beam and a needle holder of figure 5A;
Figure 6A shows a second embodiment of a local coil apparatus according to the present invention having a cross beam and needle holder in plan view;
Figure 6B shows a detailed view of the cross beam and needle holder of figure 6A;
Figure 7 shows a detailed view of the needle holder;
Figure 8 shows a plan view of the first part of a local coil apparatus according to the present invention having an intervention opening;
Figure 9A shows a perspective view of a two-part MRT local coil apparatus according to the present invention having two window like intervention openings;
Figure 9B shows a perspective view of a further two-part MRT local coil apparatus according to the present invention having two window like intervention openings;
Figure 10A shows a plan view on a first part of the local coil apparatus shown in figure 9 having two intervention openings;
Figure 10B shows a plan view of the second part of the local coil apparatus according to figure 1 or figure 9;
Figure 10c shows plan views of further embodiments of the first and second coil parts;
Figure 11 shows examples of different shapes of antenna elements;
Figure 12 shows further arrangements of antenna elements and intervention openings;
Figure 13 shows a practical application of the invention in diagnostics;
Figure 14 shows a practical application of the invention in intervention;
Figure 15 shows schematically the application of the local coil apparatus of the present invention for puncturing of the prostate;
Figure 16 shows an exploded view of a first embodiment of a MRT local coil apparatus having the MRT perineal local coil apparatus;
Figure 17 shows an exploded view of a first embodiment of a MRT local coil apparatus having the MRT perineal local coil apparatus;
Figure 18 shows an exploded view of a second embodiment of a MRT local coil apparatus having the MRT perineal local coil apparatus;
Figure 19 shows a perspective view of a second embodiment of a MRT local coil apparatus having the MRT perineal local coil apparatus; and
Figure 20 shows an application of the invention for intervention on the side of the abdomen.

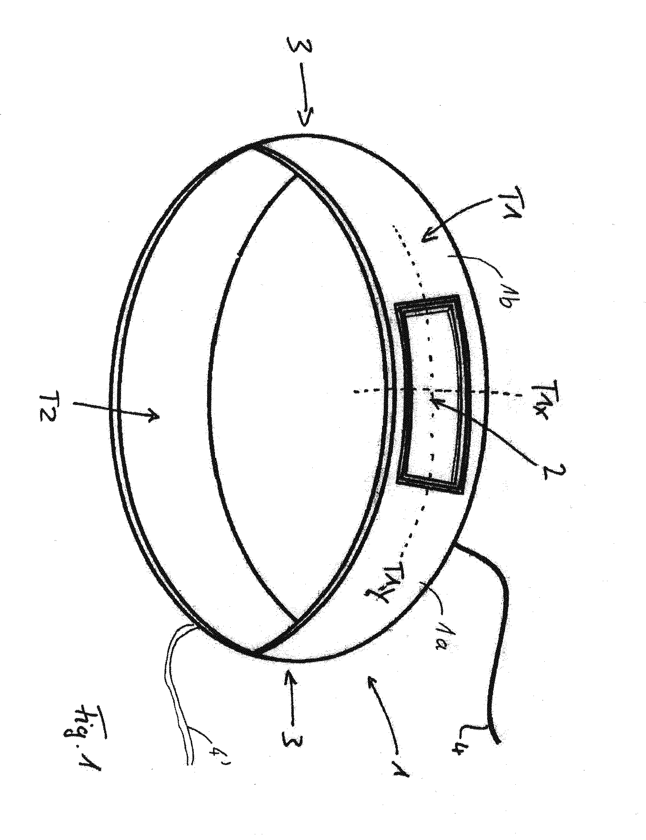

The following explanations apply correspondingly for coil apparatus having one or more intervention opening(s). The properties of the intervention opening described in the following, particularly in figures 1 to 6B, may be comprised accordingly from a local coil apparatus having one or a plurality of intervention openings. Similar subject matter applies also for elements cooperating with the intervention opening.

The local coil apparatus 1 comprises at least one intervention opening 2 in a carrier 1a, 1b. The carrier is formed in belt shape or cuff shape. The carrier is preferably flexible but it may comprise also rigid sections or portions, or it may be formed completely rigid. In this case for a form fit attachment at the patient to be examined cushion parts or the like must be inserted such that the local coil apparatus can not be moved with respect to the patient during the treatment or measurement. Preferably, a flexible cuff is provided which is merged at a connection location 3 by a connection means. The connection is preferably placed such, particularly laterally placed, that the patient to be examined is not lying on it. Particularly, the local coil apparatus 1 may comprise two separate carrier portions T1 and T2, wherein the at least one intervention opening 2 is provided in the first carrier portion T1. The signals from the local coil apparatus 1 are transmitted by two connecting lines 4, 4' to the evaluation means of a (not shown) tomograph.

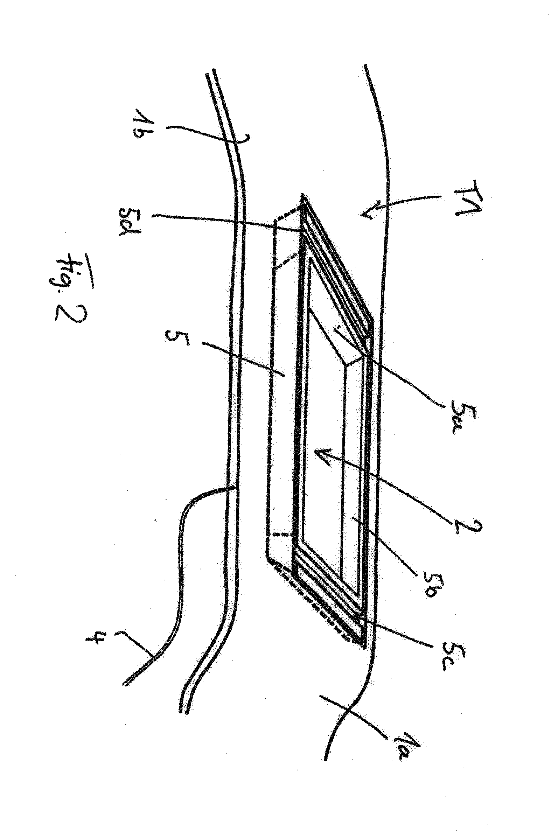

In figure 2 the region of the at least one intervention opening 2 is displayed in more detail. Between the two parts 1a, 1b of the local coil apparatus forming the cuff 1a frame 5 surrounding the intervention opening 2 may be recognized. The flexible parts 1a and 1b of the carrier in which the antenna elements K are provided, are connected at the opposite side of the rectangular frame 5 of the shown example. The frame 5 comprises at its inner side inclined sliding surfaces 5a, 5b provided at adjacent sides of the frame 5 and wherein the sliding surfaces are inclined with respect to the middle of the frame 5, accordingly to the middle of the intervention opening 2. Further, guides 5c, 5d may be recognized at opposite sides of the frame 5 at which attachment parts may be attached and guided, respectively. In the example shown the guides 5c, 5d are located between the intervention opening 2 and respectively one cuff part 1a, 1b of the local coil apparatus 1.

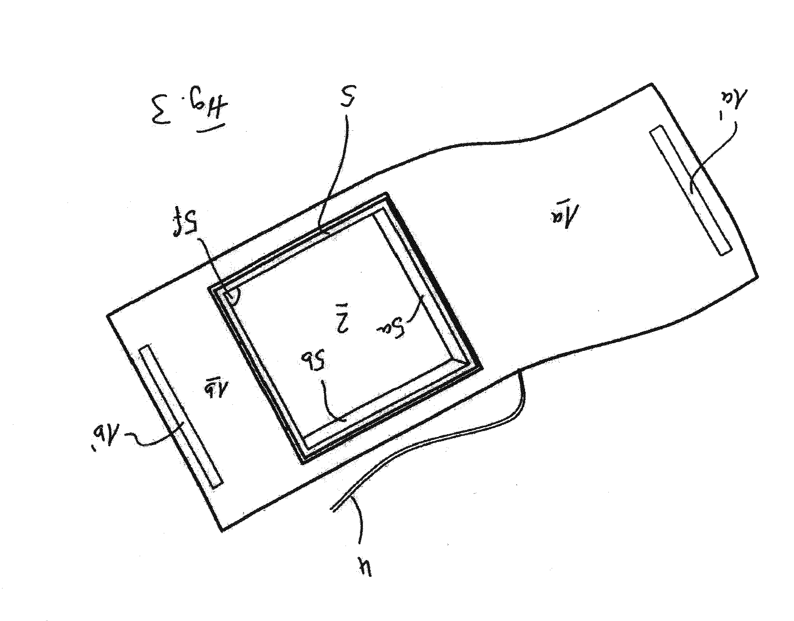

Figures 3 again shows the local coil apparatus 1 in its open form, wherein for closing of the cuff in this example Velcro connectors 1a' and 1b' are provided at the respective end of the two cuff parts 1a, 1b that are distal from the frame 5. The sliding surfaces 5a, 5b are provided for a defined alignment of a reference element, which serves for an exact positioning and locating of the coordinates in the MRT image. Thereby, the acquired imaging data may be assigned to a relative position with respect to the frame 5 unambiguously. Therefore, it is necessary that the reference element which can be seen in the MRT image can not be moved during image acquisition.

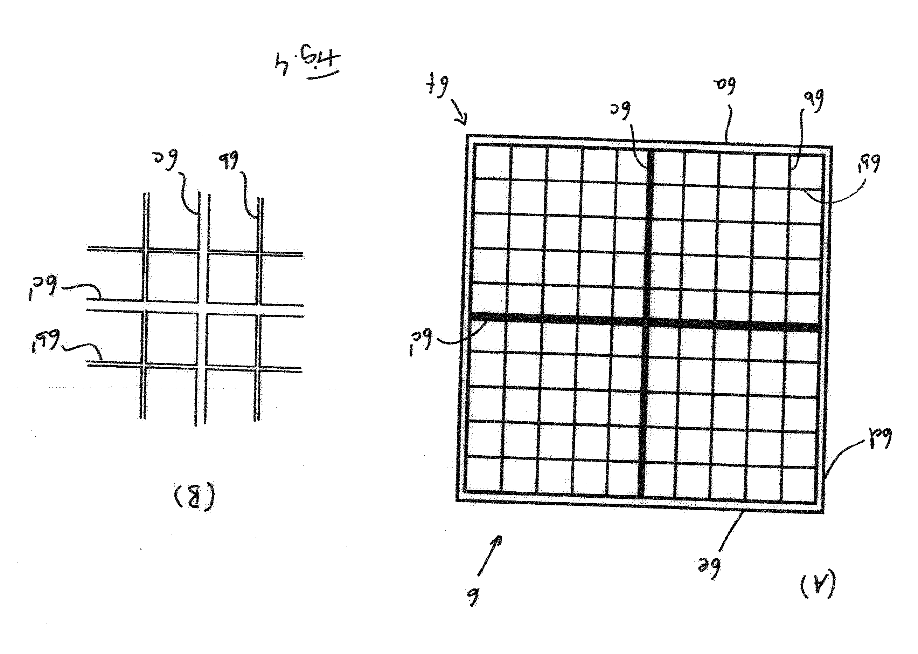

The reference element 6, which is shown in figure 4, is preferably a grid, wherein the outline shape thereof is adapted to the shape of the intervention opening 2 such that it may be inserted into the intervention opening 2. The reference element is arranged during diagnosis and/or intervention of the prostate at the back of the patient. In this example the grid is a tube grid. In the interior of the tubes 6b, 6b', 6c, 6c' an appliance visible in an MRT image is located, for example fish oil. A tube cross, preferably the middle tube cross, in the shown rectangular grid comprises thicker tubes 6c, 6c' such that it may be distinguished in the MRT image from the remaining tubes and such that it allows to determine the exact position of the lesion in the MRT image relative to the grid. If the reference element 6 is inserted into the frame, the sides 6d, 6e rest on the sliding surfaces 5a, 5b of the frame 5. Due to gravity the grid 6 "slides" in this region at the sliding surfaces 5a, 5b downwards such that the corner 6f of the frame 6 is pressed into the corner 5f of the frame and abuts securely there. Advantageously, at least in the region of the corner 5f a rest is located such that the grid 6 cannot fall downwards from the frame 5.

With the reference element 6 it is possible to determine in the MRT image the relative position between the local coil apparatus 1 and the lesion to be monitored. Particularly, in this way the insertion position of a puncturing needle and/or the insertion path for an instrument may be determined and marked at the body of the patient. The reference element is then removed for puncturing, and for the following treatment the intervention opening 2 may be used for puncturing and/or intervention in its entire area.

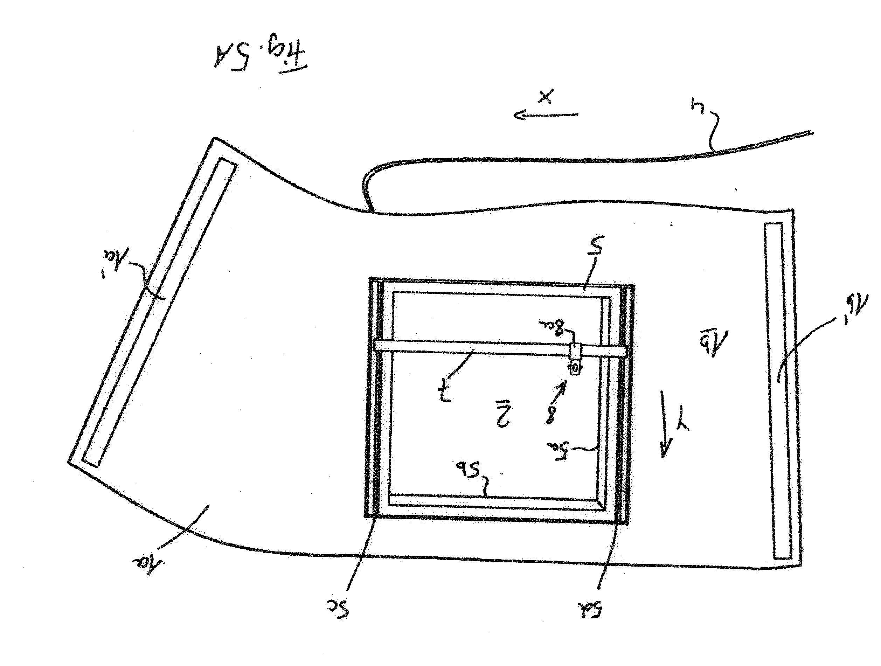

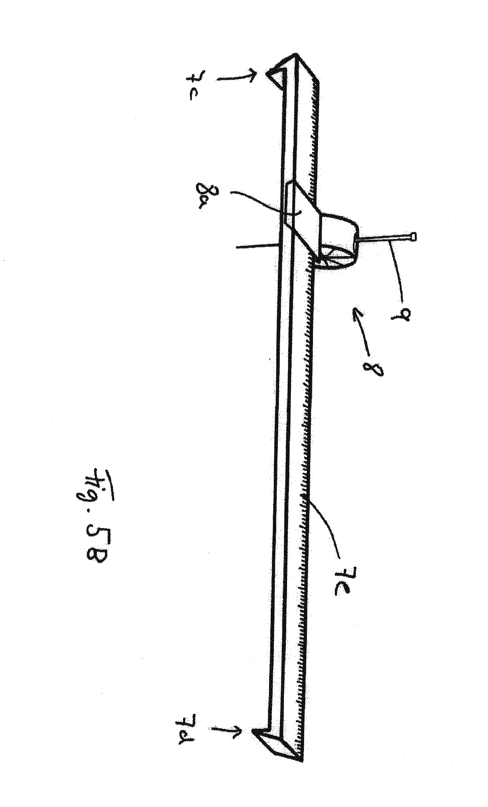

Figure 5a shows a plan view of a local coil apparatus 1 according to the present invention in which the intervention opening 2 and the frame 5 are complimented with one or more attachment parts 7, 8. Ideally, the intervention opening comprises for most of the applications an extension of approximately 7 cm to approximately 20 cm (preferably approximately 8 cm to approximately 10 cm) in carrier longitudinal direction and in cuff longitudinal direction X respectively, and an extension of approximately 7 cm to approximately 20 cm (preferably approximately 8 cm to approximately 10 cm) in the direction Y transverse to the carrier and the cuff 1, respectively. In this case one of the shown attachment parts 7 is provided as a cross beam, spanning the intervention opening 2 in direction X and which is guided in guides 5c, 5d. The cross beam 7 extending in direction X is supported movably in the guides formed preferably by slots 5c, 5d and may be fastened in an arbitrary position by suitable fastening means (screws or the like).

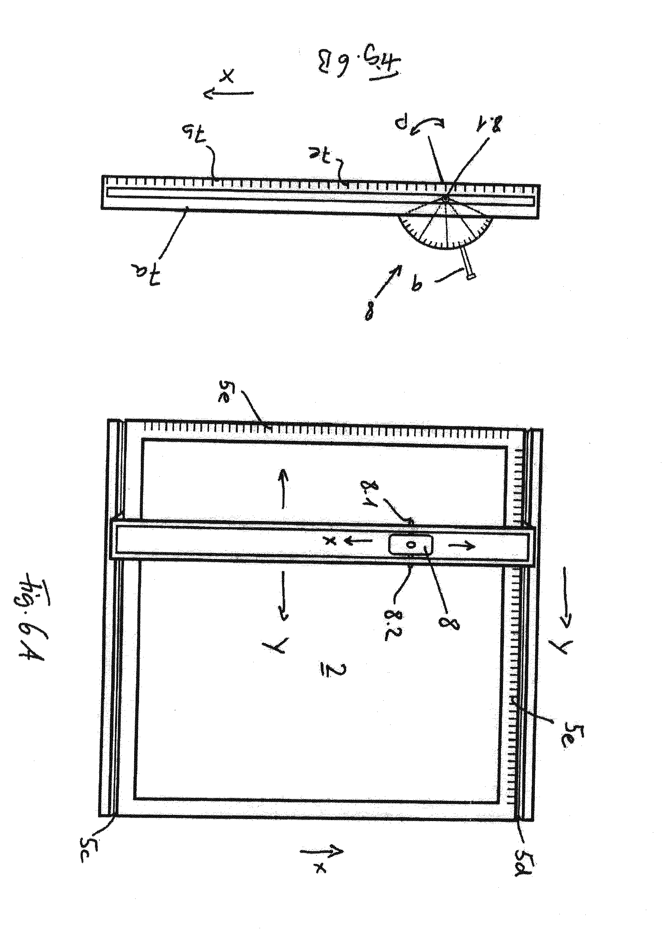

The cross beam 7 shown in figure 6 more detailed is guided with its ends 7c and 7d in the guides 5c, 5d. Preferably, the cross beam 7 and the guides 5c, 5d are formed with back taper such that the cross beam 7 cannot be loosened from the guide and separated from the frame, respectively in use. The frame 5 and the sides thereof as well as the cross beam 7 comprise in the shown example scale lines or other marks 5e (in metric or other units) in order to adjust the exact position of the cross beam 7 to the frame 5 and also the position of the below described instrument holder and needle holder 8, respectively with respect to the cross beam 7 in an exact manner. At the cross beam 7 that may be lowered in the middle section with respect to the sides 7d, 7c, but does not have to be lowered, an instrument holder and a needle holder 8, respectively for accommodating and holding an instrument and a needle 9, respectively is provided. The instrument holder and the needle holder 8, respectively is formed at the cross beam 7 movable and at least formed movable relatively to the frame 5 in at least one direction X, respectively. In the example shown the instrument holder and the needle holder 8, respectively is attached to a slide 8a and thereby movable with respect to the cross beam 7. The needle 9 may be adjusted in different angle positions and may be guided by means of the cross beam 7 to the insertion location.

In figures 6A and 6B an alternative embodiment of the cross beam 7 is shown. The frame is the same as with the embodiments described above, wherein in this embodiment additional scales and marks 5e are provided on the frame (which may also be provided on the other embodiments) in order to determine particularly the position of the grid lines 6b, 6c of the reference element 6 with respect to the frame 5. The marks 5e provided at one or more sides of the frame 5 serve accordingly as a ruler for determining of positions on the patient body, such as for determining the insertion site for biopsy. The needle holder is in this embodiment guided in the cross beam 7, and accordingly, may be moved in the direction X, which is the longitudinal direction of the cross beam 7. By means of guiding elements 8.1, 8.2 the instrument holder and needle holder 8, respectively are guided between guide rails 7a, 7b arranged above each other of the cross beam. As can be seen in figure 6B the instrument holder and the needle holder 8, respectively may also be pivoted in the guide 7a, 7b in a plain perpendicular to the moving direction Y of the cross beam 7 in a direction of arrow P. A scale 10 is provided for reading and adjusting the desired needle angle.

On the instrument holder an arbitrary medical instrument may be arranged. The medical instrument may be a diagnostic instrument or an operation instrument. In the following the invention is described in the context of a needle holder more detail.

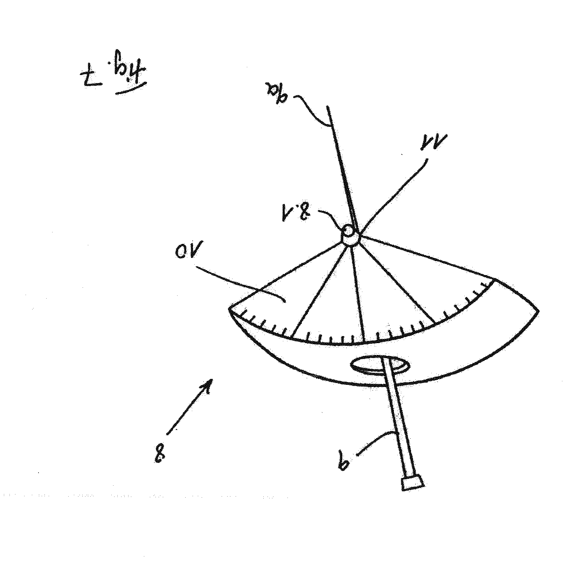

Schematic figure 7 shows the needle holder 8 in more detail. The needle 9 is locked in the holder 8 and may be adjusted angularly the in the shown example around the pivoting bearing 11 or the like. The guiding element 8.1 shown in the figure 6A, 6B also forms a rotation axis. By a scale 10 on the holder 8 and/or the guiding element 8.1 or line markers the angle may be adjusted as required to the requested injection angle. Further, the needle may be moved in the holder 8 and can be secured in any moving position by a securing mechanism not shown in detail in order that the needle 9 may approach the injection position with its tip 9a. Preferably, the needle 9 is guided such that it passes through the rotation axis of the needle holder 8.

According to one further embodiment of the invention the positions of the attachment parts may also be detected electronically and controlled electronically, respectively such that a computer aided positioning of the needle 9 at the injection site is possible in principle.

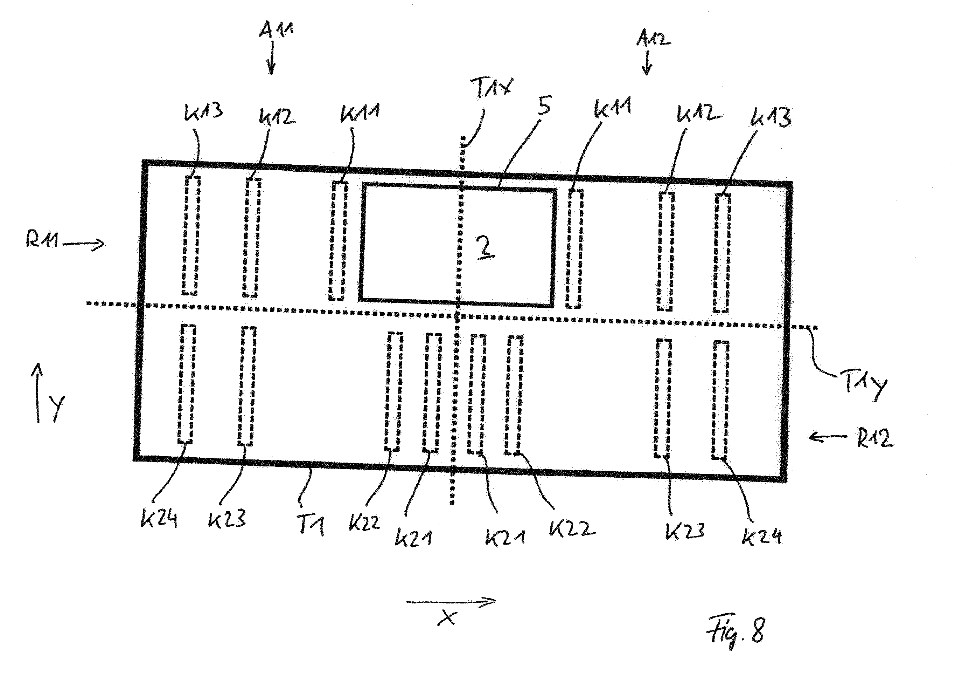

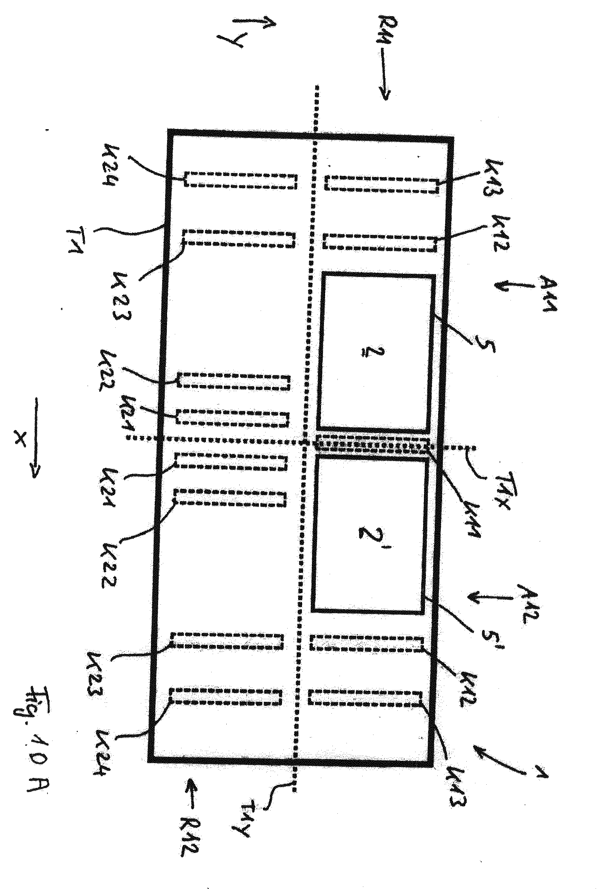

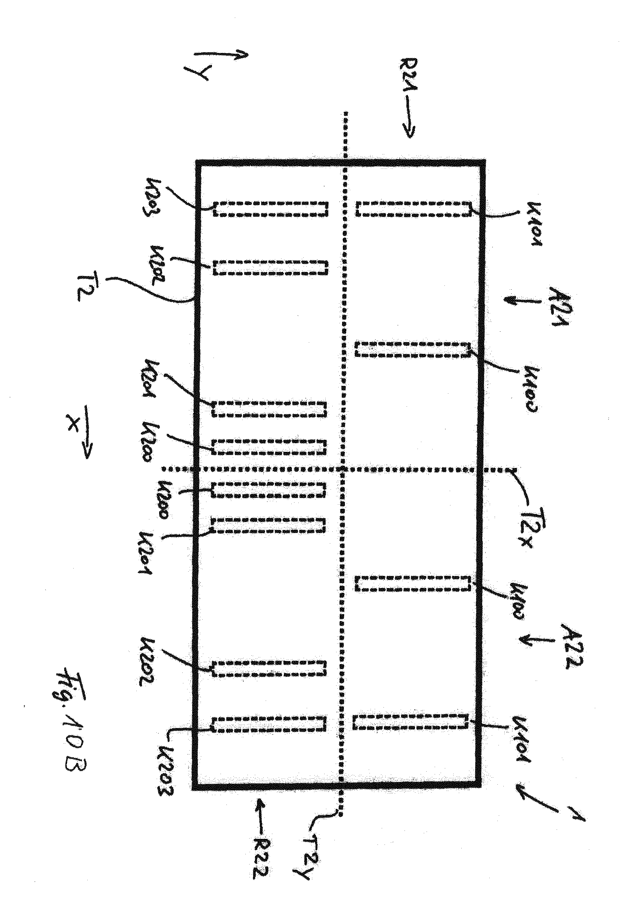

In figure 8 a schematic view of the first carrier portion T1 of a local coil apparatus according to the present invention having an intervention opening 2 is shown. There is shown the upper part of the local coil apparatus 1, which is thus that part of the two-part local coil apparatus 1, which is positioned on the patient. The "lower" second part T2 of the local coil apparatus is described below under reference to the exemplary embodiment shown in figures 10A and 10B more detailed. The explanations for these embodiments apply also for the embodiment shown in figure 8, wherein the difference is merely that the present example merely comprises one intervention opening 2. The present description also applies for figures 10A, 10B. The carrier portion T1 is adapted such that the intervention openings 2 may be arranged in cranio-caudal direction at the position of the prostate of a patient dorsal (rear side of the pelvis) over the pelvis minor. The access to the prostate is carried out right or left of the natal cleft of the patient and paramedial, respectively right or left of the natal cleft.

Preferably, the intervention opening is provided in the upper row R11 as shown in the figure in a central position, i.e. the intervention opening is arranged preferably mirror-symmetric to an imaginary centerline T1X, which separates the first part in sections A11 and A12. The sections may have equal size, although this is not necessarily required. An imaginary horizontal line T1Y separates the first carrier portion T1 in two rows R11 and R12. In the rows R11 and R12 antenna elements and channels, respectively are arranged, wherein the antenna elements K11 - K13 are arranged in the upper row R11 and antenna elements K21 - K24 are arranged in the lower row R12. Preferably, the respective antenna elements or channels K11 are located juxtaposed to the boarder or frame 5 of the intervention opening 2 to receive appropriate signal power. In the upper row at least three antenna elements are provided, wherein it is possible to arrange one antenna element in the middle of the window (not shown) approximately on the line T1X. The remaining channels not located adjacent to the intervention opening 2 are distributed equidistant on the entire longitudinal extension of the part 1. Generally, it is advisable to increase the density of the channels and antenna elements, respectively, where in the field of application the most exact MRT signals are required, i.e. at the locations of the local coil apparatus located next to the part of the body to be examined. Thus, four antenna elements and channels K21, K22, respectively are arranged in the shown example in the lower row in the region of the middle line preferably in a density that is technically feasible and appropriate, wherein the remaining antenna elements and channels K23, K24, respectively comprise a higher spacing, since particularly in the region of the abdomen no high signal power and image resolution, respectively is necessary at these places. The border of the pelvis major is detected by antenna elements K12, K13, K23, K24.

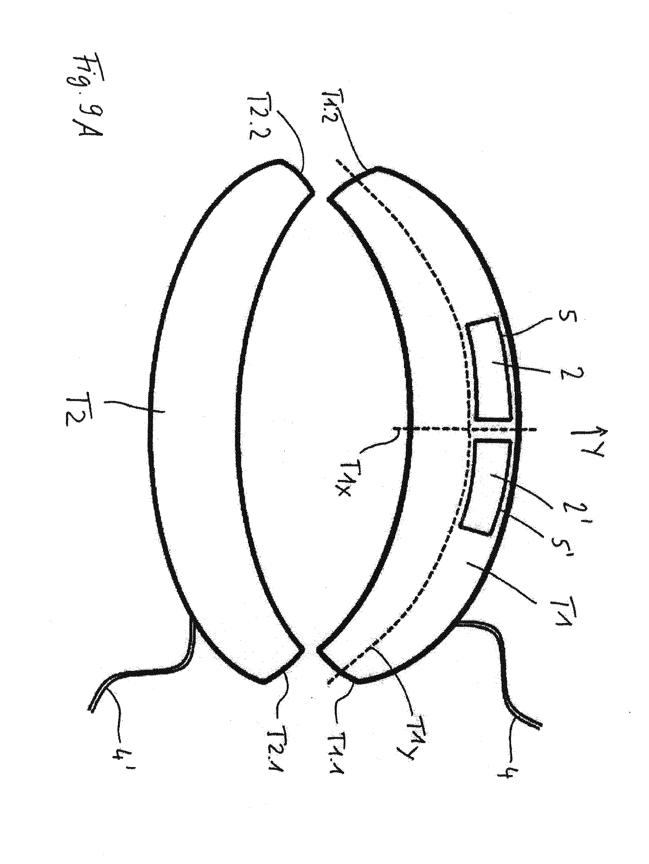

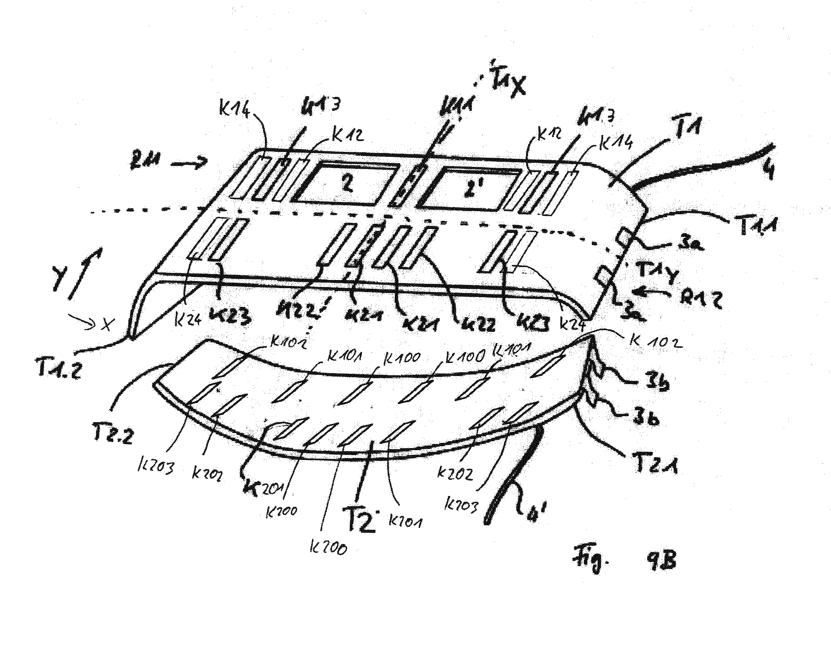

A particular embodiment of the invention is shown schematically in figures 9A, 9B, 10A and 10B. The local coil apparatus 1 is in this embodiment particularly suited for diagnostics and biopsy of the prostate and comprises two carrier portions, i.e. an upper first carrier portion T1 and a lower second carrier portion T2, which are connected at the respective ends (X-direction) together. "Upper" and "lower" refer to the herein preferred application, in which the patient lying on the abdomen lies with his pelvis on the lower second carrier portion T2, and in which the upper first carrier portion rests on the patient. The following merely refers to the first and second carrier portion. The two carrier portions comprise ends T1.1, T1.2 and T2.1, T2.2, respectively at which they can be connected via Velcro connectors, belts or the like in order to secure the local coil apparatus 1 in total at the body of the patient in a manner that it cannot move. These parts may be controlled and read, respectively over signal lines 4, 4' separately.

The two-part local coil apparatus shown in figure 9B corresponds essentially to the apparatus shown in figure 9A. The local coil apparatus and the first carrier portion T1 are in their diagnosis position. The difference is herein that the upper carrier portion T1 comprises an essentially plain and at least relatively rigid middle portion and that it is formed at the ends T1.1, T1.2 flexible or curved in direction of the second carrier portion. Thereby, operations in this region is facilitated, and particularly it is possible to facilitate by the planar form at least in the region of the window or intervention opening 2, 2' the attachment of the cross beam and of reference elements and their handling. The ends may be connected, as is shown herein at one side for example by Velcro connectors 3a, 3b or belts, wherein the distance between the carrier portions T1, T2 may vary in this way according to the size of the patient. The second carrier portion T2 is preferably formed flexible such that no pressure points are caused on a patient lying thereon.

During examination of the prostate the patient is lying on his back on the second carrier portion T2. During intervention of the prostate the patient is lying with the abdomen on the second carrier portion T2.

A plurality of antenna elements K200, 201 is arranged in the region of the pelvis minor both during diagnosis and intervention. These antenna elements K200, 201 are located in longitudinal direction X of the second carrier portion T2 centrally and in cross direction Y of the second carrier portion T2 downwards. In the example shown in figure 9b four antenna elements K200, 201 are located in the region of the pelvis minor, in a sagittal (dorsal) direction under the pelvis minor, for example. Thereby, an appropriate imaging of the prostate may be achieved. In cross direction Y of the second carrier portion T2 in the upper portion a plurality of antenna elements K100, K101, K102 are distributed essentially equidistant along the longitudinal direction X over the second carrier portion T2. In the example shown in figure 9b six antenna elements K100, K101, K102 are distributed along the longitudinal direction X of the second carrier portion in a portion, which is located in cross direction Y of the second carrier portion T2 in the upper region. However, it is possible to arrange the antenna elements K102, K102 at the apparatus of the pelvis major in a higher density. On the lower edge of the pelvis major two antenna elements K202, 203 are located each. These antenna elements K202, 203 are located in longitudinal direction of the second carrier portion T2 respectively at the edge and in cross direction of the second carrier portion T2 in the lower region.

The first carrier portion T1 shown in figure 10A comprises two intervention openings 2, 2' enclosed by frame 5, 5'. The configuration of the intervention openings 2, 2' and the frame 5, 5', respectively may be provided as has been described above with respect to the other embodiments such that to their description is referred in order to avoid repetitions. The arrangement of the intervention openings 2, 2' may be provided, as is shown herein, in direction X adjacent on both sides of a first separation line T1X separating the first part into sections A11, A12, and above a second separation line T1Y, which separates the first carrier portion T1 in two rows R11 and R12. In the shown example the intervention openings 2, 2' are arranged accordingly in the first row R11, wherein one intervention opening 2 is located in section A11 and one intervention opening 2' is located in section A12. Also, an embodiment is conceivable in which the intervention openings are located in one row, but underneath in the same section.

Further, it is possible to recognize by the reference sign K11... K 24 transmission means and/or reception means, termed antenna elements. The antenna elements are termed in the medical practice also as channels. The local coil apparatus is termed in the medical practice also MRT coil or just coil. The number of antenna elements and channels, respectively per area (and therefore finally the resolution of the MRT signals) is not fixed and may be varied. Particularly, signals of a plurality of transmitting and/or reception means in the local coil apparatus 1 may be combined to a single channel. The arrangement of channels indicated herein is to elucidate merely, in which regions of the local coil apparatus a higher channel density is required in order to achieve particularly in the region favored herein of the human pelvis appropriate MRT signals. Since two intervention openings 2, 2' are provided according to the present invention, for obtaining a qualitatively good signal it is essential that at least one antenna element and one channel K11, respectively is arranged between the intervention openings 2, 2'. During an examination of the pelvis this antenna element K11 is located directly over the natal cleft and therefore also directly above the prostate and in the longitudinal direction of the patient, respectively at the same position as the prostate such that in this portion a sufficiently appropriate signal power may be realized. The antenna element K11 is positioned in sagittal (ventral) direction above the prostate. Further outside additionally the channels K12, K13 are positioned in a larger distance. The intervention openings 2, 2' may be two separate intervention openings or may be formed by the one intervention opening, however.

In the second row R12, in which no intervention openings are provided, in the region around the middle line T1X antenna elements K12, K22 are positioned under a small distance (as small as technically feasible) adjacent to each other, wherein the antenna elements K23, K24 positioned further outwards comprise a larger distance to each other in comparison.

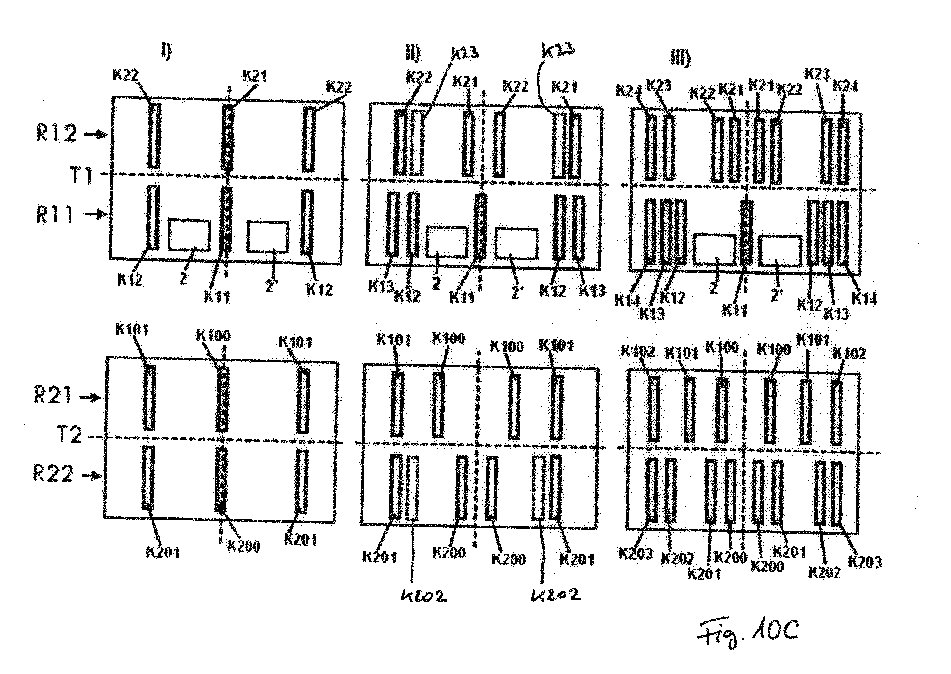

The configuration of the first carrier portion is described below under reference to figure 10C iii), wherein it is to be noted that the first carrier portion T1 is arranged in figure 9B in its diagnosis position and arranged in figure 10c iii) in the intervention position.

The second carrier portion T2 shown in figure 10B of the local coil apparatus 1 is divided by a separation line T2X into sections A21 and A22, and by a separation line T2Y in rows R21 and R22. The second row R22 of the second carrier portion preferably comprises the same channel arrangement of the antenna elements K200 to K203 as the second row R12 of the first carrier portion T1 (see figure 10A). The first row, which has to provide signals of the region of the pelvis major during pelvis diagnostics, comprises merely four antenna elements K100, K101 which are relatively wide spaced from each other. It is possible to arrange more antenna elements, particularly eight antenna elements, which may be spaced apart by the same distance, if desired during pelvis examination. Due to the anatomy of the pelvis these antenna elements are generally not necessarily required. The second row R22 requires in the middle of the measurement window a higher resolution.

For the diagnosis of the pelvis the rows R11 of the first carrier portion and R21 of the second carrier portion are arranged above each other. For the MRT based biopsy of the prostate the first carrier portion may be rotated 180° such that the first row R11 of the first carrier portion is positioned above the row R22 of the second carrier portion T2, and the row R12 of the first carrier portion T1 is positioned above row R21 of the second carrier portion. Thereby, it is also possible during biopsy to achieve sufficiently appropriate MRT signals in the region of the intervention openings 2, 2', since the signals of the antenna element K11 (above the prostate) and the antenna elements K200, K201 (under the prostate) may be used.

In figure 10C further examples for the configuration of the antenna elements in the local coil apparatus are shown, wherein the first carrier portion T1 is depicted in the upper section and the corresponding second carrier portion T2 is depicted respectively below.

The first carrier portions are arranged in their "biopsy position", i.e. with a first part rotated 180° such that the intervention openings are positioned in the drawing in the lower section corresponding to the position above the natal cleft of the patient. For diagnosis the first parts T1 are rotated again about 180°, as this is the case in figure 10A, for example.

The remaining nomenclature corresponds to the above description.

The embodiments shown under i), ii) and iii) of the multipart coil apparatus distinguish merely by the arrangement of the antenna elements.

The embodiment i) comprises in all rows three antenna element each, wherein the antenna elements K11, K21, K100 and K200 are arranged centric and the remaining antenna elements are arranged on both sites of the centric arranged antenna elements.

In the embodiment ii) the first carrier portion T1 comprises four antenna elements in the second row R12, wherein the antenna elements positioned closer to the center are arranged more densely to achieve a signal having an appropriate quality in the region of the pelvis minor. A woman has the uterus, ovaries and bladder in the pelvis minor. A man has his seminal, the prostate and the bladder in the pelvis minor. In the first row R11 an antenna element distribution and channel distribution, respectively is such that corresponds to figure 10A. In the second carrier portion T2 the antenna elements K100, K101 in the first row are preferably distributed almost equidistant and symmetric to the central line. In the second row R22 the distribution corresponds to the second row R12 of the first carrier portion T1. In one embodiment additionally channels K23 may be provided in the first carrier portion T1 in row R12 and channels K202 may be provided in the second carrier portion T2 in the row R22.

In the embodiment iii) the first carrier portion T1 corresponds with respect to the channel arrangement and antenna arrangement, respectively generally to the embodiment in figure 10A, wherein at the sides in the first row R11 merely one antenna element K14 is provided additionally at the other side as compared with the embodiment in figure 10A. The lower carrier portion T2 corresponds essentially to the embodiment of figure 10B except that in the first row R21 six antenna elements are provided instead of four antenna elements.

The embodiment iii) corresponds to the embodiment shown in figure 9B, wherein the first carrier portion T1 is located in figure 9B in its diagnosis position and is located in figure 10C iii) in the intervention position. An antenna element K11 is arranged essentially central between the intervention openings 2, 2'. At the lateral sides of the intervention openings, which are respectively opposed to the other intervention opening, three antenna elements K12, K13, K14 are located. In the cross direction of the first carrier T1 four antenna elements K21, K22 are arranged in the upper portion, which are positioned in the longitudinal direction of the first carrier T1 essentially central. Two antenna elements K23, K24 each are located in the longitudinal direction of the first carrier at the outer side and in the cross direction of the first carrier in the upper portion.

The antenna elements of the embodiments shown in figures 8 to 10 are formed essentially thin. In other words, the width of the antenna elements is smaller than approximately 50%, preferably smaller than approximately 33%, more preferred smaller than approximately 25%, most preferred smaller than approximately 12.5% of the length of the antenna element. Thereby, it is possible to arrange a plurality of antenna elements in a region of particular interest.

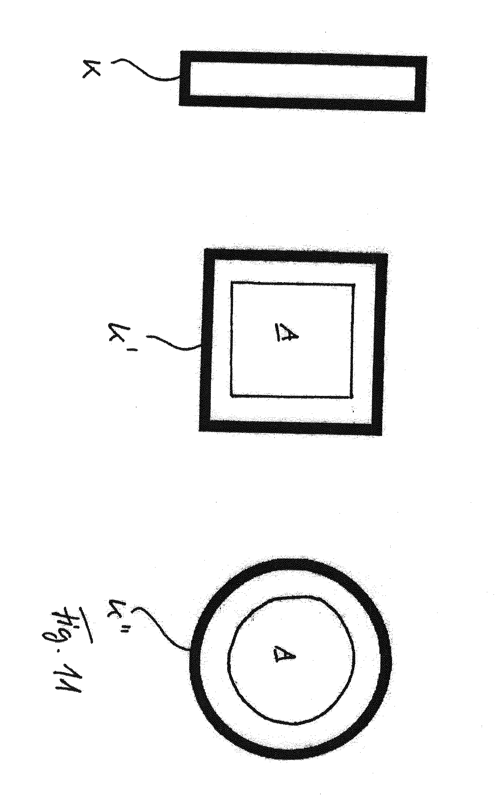

It is to be noted here that the antenna elements or channels do not have to have the shape shown in the previous figures, rather it is possible that more suitable shapes may be used. In figure 11 exemplary antenna elements and channels, respectively are shown. On the one hand, the antenna element may comprise a thin rectangular shape or stripe shape K. However, the antenna element may also have as is shown under K' and K" a broad rectangular shape, a square shape or a circular shape, and may comprise an intervention opening A in the center. Particularly, the version having the intervention opening is particularly well-suited for the medical application described in this patent application, in which the local coil apparatus comprises an intervention opening 2. The antenna element K' may be arranged around the intervention opening of the local coil apparatus, this applies both for the version having one window and two windows.

The shape of the antenna element K' also allows to arrange the window 2 in the first carrier region T1 of the local coil apparatus centrally such that the at least one intervention opening 2 is positioned - as shown in figure 1, for example - on both sides of the line T1 Y and respectively to both sites of line T1X. Besides other channels to be provided arbitrarily, one antenna element of the type K' (figure 11) is arranged around intervention opening 2. The same applies for the version having two intervention openings (such as figures 9A, 9B). Also in this case the antenna elements of type K' (see figure 11) may be arranged around the intervention openings 2, 2'. Also in the case of merely one intervention opening 2 (see figure 1) an arrangement of the intervention openings in the middle of the local coil apparatus is possible, on which the intervention openings extend on both sides of line T1Y. Above and below the centrally arranged intervention openings 2, 2', respectively further rows with channels and antenna elements, respectively may be provided. The applicant reserves the right to claim this aspect in a separate application, such as by a divisional application.

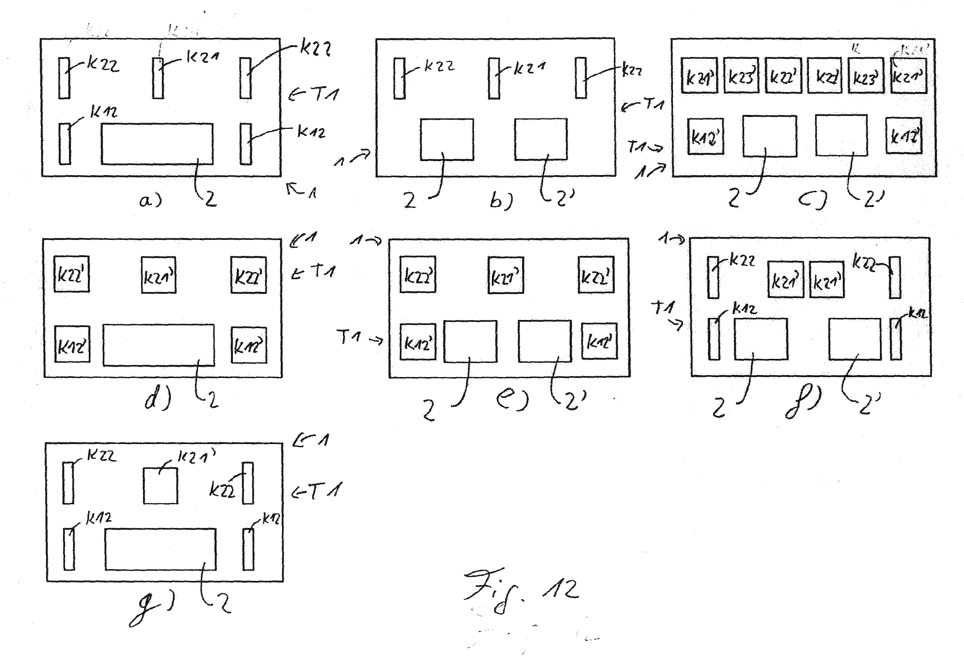

Under reference to figures 12a to 12g a further embodiment of the invention is explained, in which antenna elements having different width and/or broad antenna elements are used. A broad antenna element has a width larger than approximately 50%, preferably larger than approximately 66%, more preferred larger than approximately 75%, most preferred larger than approximately 87.5% of the length of the antenna element. A broad antenna element may receive MRT signals from a larger region. Accordingly, less channels have to be transmitted from the local coil apparatus to the evaluation device.

The local coil apparatus 1 according to figure 12a comprises an intervention opening 2. Beside the intervention opening 2 an antenna element K12 is arranged each. In the cross direction of the first carrier portion in the upper region three antenna elements K21, K22 are arranged in longitudinal direction of the first carrier portion T1 essentially equidistant.

The local coil apparatus 1 according to figure 12b comprises two intervention openings 2 and 2'. In cross direction of the first carrier portion in the upper region three thin antenna elements K21, K22 are located, arranged in longitudinal direction of the first carrier portion T1 essentially equidistant. However, no antenna elements are arranged beside the intervention openings.

The local coil apparatus 1 according to figure 12c comprises two intervention openings 2 and 2'. Beside the group of intervention openings 2, 2' a broad antenna element K12 is arranged each. In cross direction of the first carrier in the upper region six broad antenna elements K21', K22', K23' are arranged in longitudinal direction of the first carrier portion T1 essentially equidistant.

The local coil apparatus 1 according to figure 12d comprises one intervention opening 2. Beside the intervention opening 2 one broad antenna element K12' is arranged each. In cross direction of the first carrier portion in the upper region three broad antenna elements K21', K22' are arranged, which are arranged in longitudinal direction of the first carrier portion T1 essentially equidistant.

The local coil apparatus 1 according to figure 12e comprises two intervention openings 2, 2'. Beside the group of intervention openings 2, 2' a broad antenna element K 12' is arranged each. In cross direction of the first carrier portion T1 in the upper region two broad antenna elements K21', K22' are arranged, which are arranged in the longitudinal direction of the first carrier portion T1 essentially equidistant.

The local coil apparatus 1 according to figure 12f comprises two intervention openings 2, 2'. Beside the group of intervention openings 2, 2' a thin antenna element K12 is arranged each. In cross direction of the first carrier portion T1 in the upper region two broad antenna elements K21' and two thin antenna elements K22 are arranged. The broad antenna elements K21' are arranged in longitudinal direction of the first carrier portion T1 in the central portion. The thin antenna elements K22 are arranged in the longitudinal direction of the first carrier portion T1 at the edge.

The local coil apparatus 1 according to figure 12g comprises one intervention opening 2. Beside the intervention opening 2 a small antenna element K12 is arranged each. In cross direction of the first carrier portion T1 in the upper region one broad antenna elements K21' and two thin antenna elements K22 are arranged. The broad antenna element K21' is arranged in longitudinal direction of the first carrier portion T1 in the central region. The thin antenna elements K22 are arranged in longitudinal direction of the first carrier portion T1 at the edge.

In the embodiment according to figures 12a to 12g one antenna element may be arranged around the intervention opening 2, 2' or around a plurality of intervention openings 2, 2'.

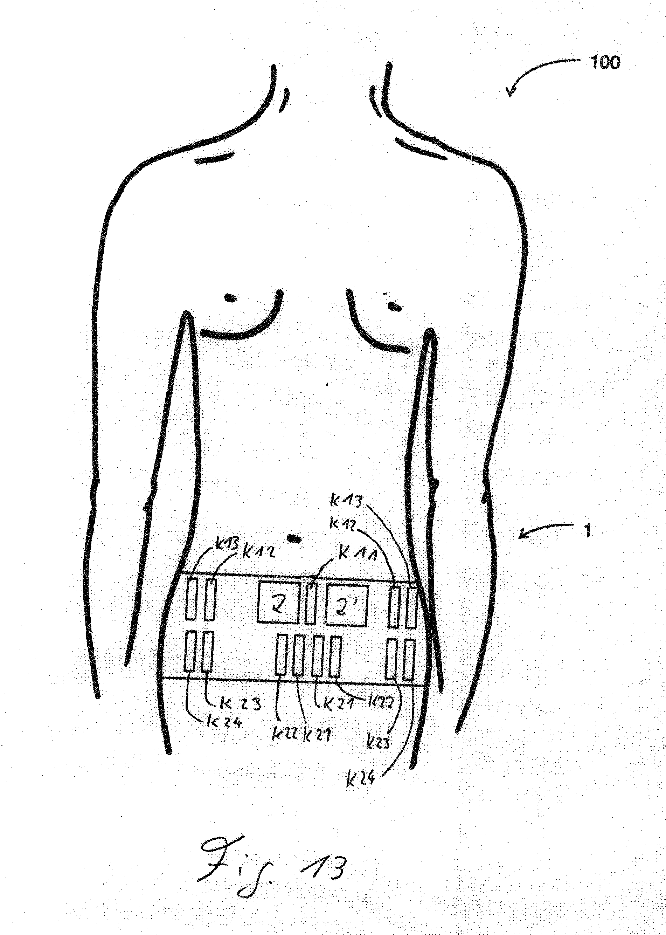

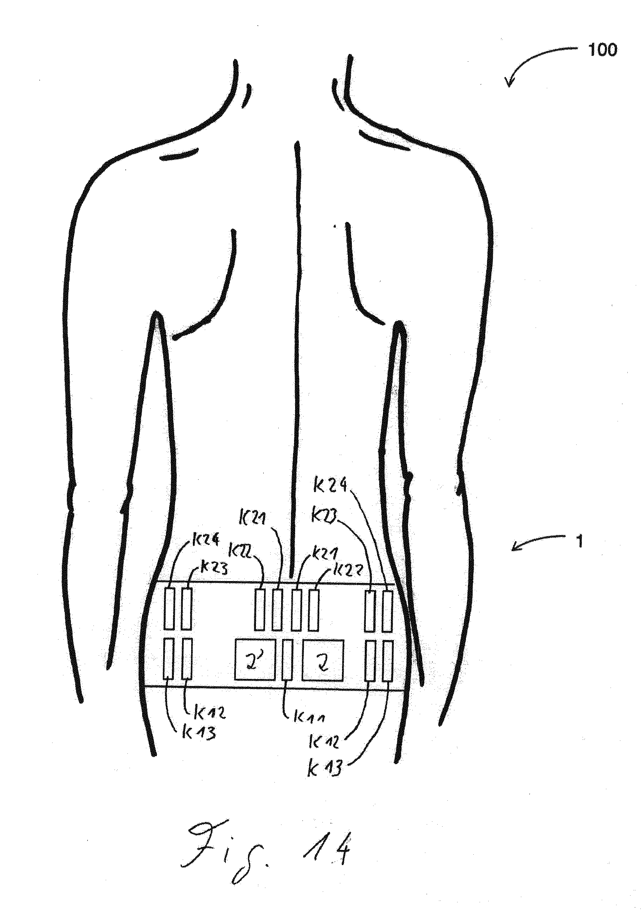

Below, under reference to figures 13 and 14 a practical application of the invention during treatment of the prostate is explained, in which the back of a patient 100 is displayed schematically.

The MRT local coil apparatus 1 acts in the position shown in figure 13 as a diagnosis coil apparatus. The patient lies with his back on the second carrier portion T2 (not shown). The second carrier portion T2 can be configured such as has been described according to figures 9B, 10B and 10C. The first carrier portion is in its diagnosis position. In the diagnosis position the antenna elements K21 and K22 are located ventral above the pelvis minor and in longitudinal direction of the patient, respectively on the same position as the pelvis minor. A woman has her ovaries, uterus and bladder in a central portion of the pelvis minor. Accordingly, in the diagnosis position a particularly accurate imaging of the pelvis minor may be achieved. A male has his prostate, seminal gland and bladder arranged in the central region of the pelvis minor.

In the diagnosis position the antenna element K11 is located at a middle portion of the pelvis major, in which mainly the intestinal loops are located. The intestinal loops are during therapy of the prostate carcinoma of lower importance, since this region is generally affected by metastases due the prostate carcinoma to a lower extent.

The antenna elements K12 and K13 are located at the edge of the pelvis major. This region is affected by metastases of the prostate carcinoma or a carcinoma of another organ to a larger extent, since this portion comprises a large number of lymph vessels. Due to the venous blood flowing from the prostate in direction to the edge of the pelvis major, the lymph nodes at the edge of the pelvis major are infested more frequently by metastases of the prostate carcinoma or a carcinoma of a different organ.

In the diagnosis position the antenna elements K12, K13, K21 and K22 are arranged above parts of the body that are of particular medical relevancy during diagnosis, i.e. above the pelvis minor and the edge of the pelvis major.

Figure 14 shows the intervention position of the first carrier portion T1. The patient lies with his abdomen on the second carrier portion. The patient rests in abdominal position. The intervention openings 2, 2' are located dorsal above the pelvis minor. In this position puncturing the prostate is possible. Since the antenna element K11 is located between the intervention openings 2, 2' and since the antenna elements K21 and K22 are arranged close to the intervention openings 2, 2' still a comparably appropriate imaging of the pelvis minor is possible. The rectangle circumscribing the intervention openings 2, 2' is arranged in cranio-caudal direction at the position of the prostate of the patient dorsal (in abdominal position of the patient) above the pelvis minor (rear side of the pelvis minor above the pelvis minor). The access to the prostate is accomplished right or left of the natal cleft of the patient and paramedian and, respectively right or left of the natal cleft (abdominal position of the patient).

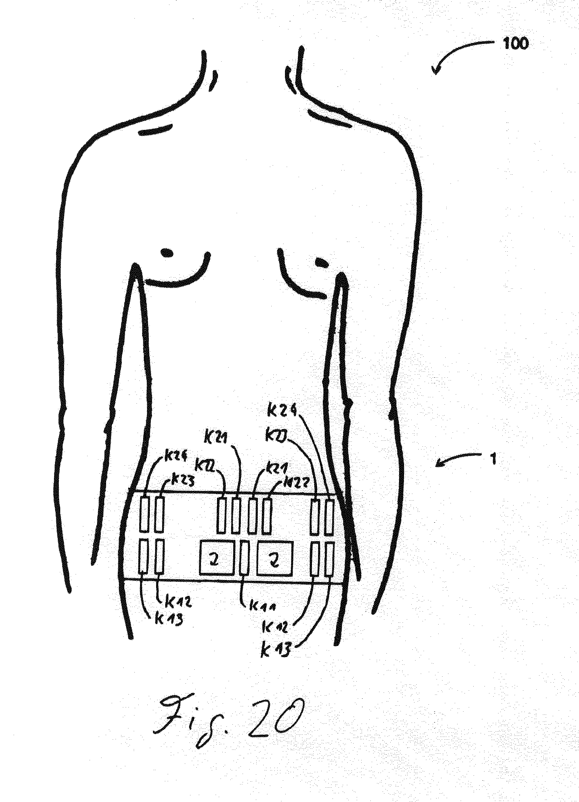

In case of an intervention of other organs in the pelvis minor the intervention opening may be located ventral (abdominal sides) (in supine position of the patient), i.e. in cranio-caudal direction at the position of the pelvis minor and ventral of the pelvis minor. Such arrangement is shown in figure 20. Figure 20 shows a further intervention position of the first carrier portion T1. The patient lies with his back on the second carrier portion (supine position of the patient). The intervention openings 2, 2' are located ventral (on the abdomenial side) above the pelvis minor. In this position puncturing of organs in the pelvis minor is possible, which can be accessed ventrally. Since the antenna element K11 is located between the intervention openings 2, 2' and since the antenna elements K12 and K22 are located at the intervention openings 2, 2' still a comparably appropriate imaging of the pelvis minor is possible.

Reference is again made to figure 10B, which shows the second carrier portion. The patient lies with his abdomen on the second carrier portion T2 (not shown). The second carrier portion T2 may be adapted such as has been described with respect to the embodiments according to figures 9B, 10B and 10C. The antenna elements K200 and K201 are located always, i.e. both in the diagnosis position and the intervention position under the pelvis minor. In the diagnosis position for the prostate diagnosis the antenna elements K200 and K201 are located dorsal at the position of the pelvis minor. The patient rests in this case in supine position. In the intervention position for an intervention of the prostate, in which the patient is located in abdominal position, the antenna elements K200 and K201 are located ventral below the pelvis minor. Thereby, it can be asured that also in the intervention position of the first carrier portion T1 an appropriate imaging of the pelvis minor is possible.

In the diagnosis position the number of antenna elements in dorsal-ventral direction above the pelvis minor is higher as compared in the intervention position of the first carrier region T1. The second carrier region T2 is always arranged such that a higher number of antenna elements is located in dorsal-ventral direction under the pelvis minor.

Since the first carrier portion T1 can be separated from the second carrier portion T2 and pivoted with respect to the latter about 180° the invention provides a flexible MRT local coil apparatus, which can be used both for diagnosis and intervention. The applicant reserves the right to direct a separate application to this subject matter.

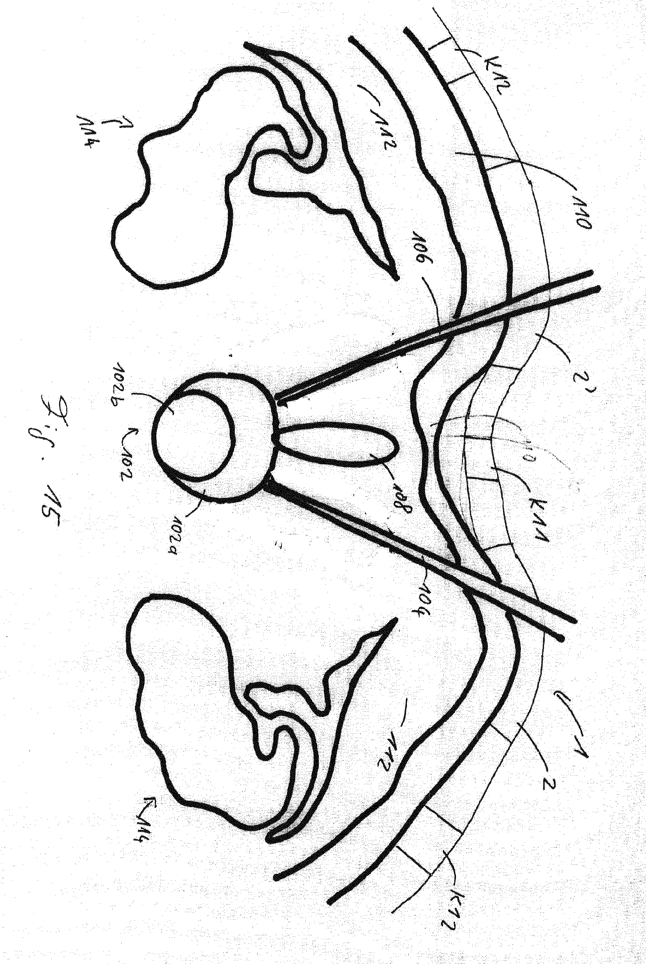

Under reference to figure 15 the application of the inventive local coil apparatus 1 during prostate puncturing is explained. Figure 15 shows a view cut along the transversal plane at the position of the prostate of a patient. Figure 15 shows the prostate 102, the hip joints 114, the large intestine 108, gluteal muscle 112 and adipose tissue 110. The prostate comprises a peripheral zone 102a and a transitional zone 102b. On the skin over the adipose tissue 110 the local coil apparatus 1 is arranged. The local coil apparatus 1 comprises two intervention openings 2, 2', arranged beside the natal cleft. Above the natal cleft and between the intervention openings 2, 2' a thin antenna element K11 is located. At the side opposite to the natal cleft of the intervention opening 2, 2' two antenna elements K12 are arranged each.

The evaluation of the MRT response signals received by means of the antenna elements allows the surgeon to perform an MRT based biopsy. During guiding the biopsy needles 104, 106 through the buttocks in the direction of the prostate, the surgeon may determine based on the image information under which angle and up to which depth the biopsy needles are to be introduced in order to extract a tissue sample from a suspicious region of the prostate. During introducing of the biopsy needles successively MRT images may be made in order to determine the current position of the biopsy needles, until the biopsy needles have reached the position of the tissue to be examined.

The method may be performed manually. It is also possible that the biopsy needles may be guided based on the MRT images automatically to the tissue to be examined.

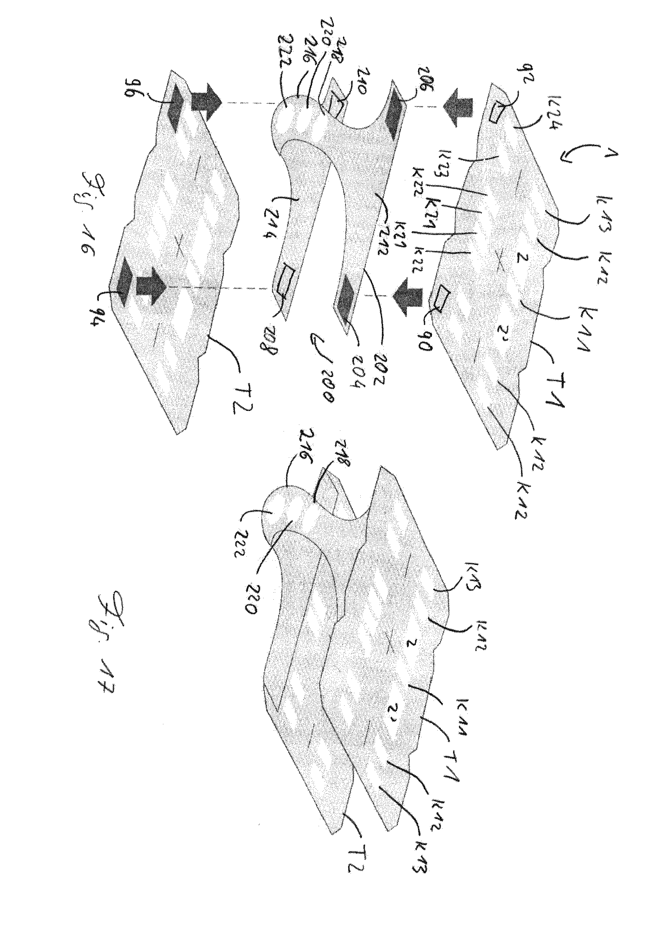

Figure 16 shows an exploded view of the MRT local coil apparatus 1 and of a first embodiment of an MRT perineal local coil apparatus 200. The arrangement of the antenna elements K11 to K24 of the first carrier T1 corresponds to figures 10A and 13 such that the description thereof is not repeated and reference is made to the description thereof. The MRT perineal local coil apparatus comprises a front carrier portion 212, a rear carrier portion 214 and a perineal carrier portion 216. The front carrier portion 214 may be secured at the first carrier portion T1 by first securing means 204, 206 with third securing means 90, 92 of the first carrier portion T1. The rear carrier portion 214 may be connected with the second carrier portion T2 by second securing means 208, 210 with forth securing means 94, 96 of the second carrier portion T2. The securing means may be Velcro connector, for example.

Figure 17 shows a perspective view of the MRT local coil apparatus 1 and the MRT perineal local coil apparatus 200, in which the MRT perineal local coil apparatus 200 is secured with the MRT local coil apparatus 1 by the first, second, third and fourth securing means. During diagnosis, during which the patient rests on his back, the first carrier portion T1 is located over the pelvis minor and pelvis major. From the pelvis minor the MRT perineal local coil apparatus 200 extends in the direction of the coccxy. At the back of the patient the second carrier portion T2 is located.

The MRT perineal local coil apparatus 200 is located in use in the perineal region, in the region of the crotch and in the region of the genitalis, respectively. Since these regions and particularly the perineal region is located close to the prostate, qualitatively appropriate images of the prostate and neighboring parts of the body and/or organs may be generated.

In the first embodiment of the invention antenna elements 218, 220, 222 shown in figures 16 and 17 are arranged in the direction from the pelvis minor to the coccxy behind each other. The antenna elements 218, 220, 222 may be formed circular, overall, square, rectangular etc., as has been described above.

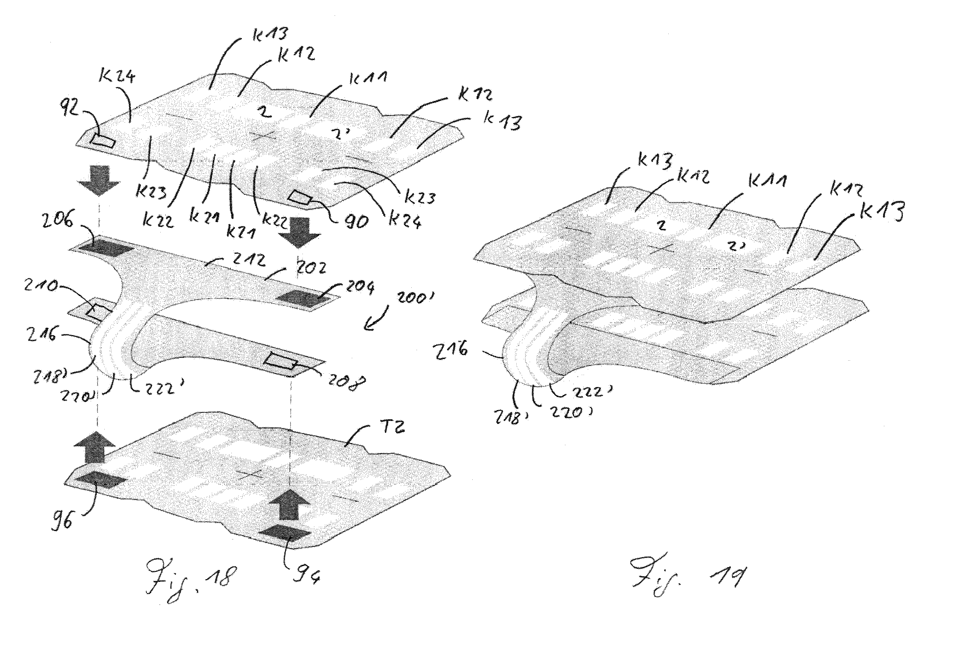

The second embodiment shown in figures 18 and 19 of the MRT perineal local coil apparatus 200' corresponds essentially to the MRT perineal local coil apparatus 200 of the first embodiment shown in figures 16 and 17. Contrary to the first embodiment the second embodiment of the MRT perineal local coil apparatus 200' comprises a plurality of antenna elements 218', 220' 222' arranged in the direction from the pelvis minor to the coccxy behind each other. The antenna elements 218', 220', 222' may be formed circular, oval, square, rectangular etc. as has been described before.

The invention allows that a biopsy of the prostate may be performed without injuring the large intestine. The invention may prevent bacteria to enter from the large intestine into the prostate during biopsy. Further, the present invention allows that biopsy may be performed with anesthesia.

The local coil apparatus according to the present invention may be used for diagnoses and/or intervention of other organs, such as the kidney, gall, pancreas etc. During diagnosis and/or during intervention the patient does not have to rest necessarily on his back and abdomen, respectively. The intervention opening may be located during diagnosis and/or during intervention of the pancreas on the abdomen, for example. Further, the intervention opening may be located during diagnosis and/or intervention of the gall lateral on the body. The intervention opening is located at a place, where the medically most appropriate access to the organ is possible.

The image data generated by the local coil apparatus according to the present invention may be transmitted to an operation navigation system, such that the course of the procedure and the positioning of the instrument may be assisted more accurately by the operation navigation system.

Generally, for all embodiments applies that logical channels process signals from at least one antenna element, but also bundle the signals of a plurality of antenna elements that are not shown in detail herein.

All embodiments of the invention may be combined also. Therefore, the invention is not limited to the embodiments shown in the figures, but comprises everything that may be construed by combining of elements from the different embodiments.

Particularly, embodiments according to figures 1 to 7 may be combined with the embodiments according to figures 8 to 15. In other words, at the intervention opening 2 and at the intervention openings 2, 2' according to figures 8 to 15 a frame, a cross beam, first and second adjustment means, marks, a scale, a reference element, a slide, an instrument holder, a needle holder, an instrument, a needle etc. may be arranged as is described under reference to the embodiments according to figures 1 to 7.

In the context of this invention the sagittal direction is the direction from the back to the abdomen and vise versa. In the context of this invention the longitudinal direction of the patient is the direction from the head to the foot or vise versa. In the context of this invention the longitudinal direction of the carrier is longer than the cross direction thereof.

## Claims

1. MRT local coil apparatus (1), having
- a carrier (1a, 1b; T1, T2); and
- at least one antenna element (K11 - K202) each adapted for receiving a plurality of MRT signals;
wherein the at least one antenna element (K, K11 - K202) is arranged in a carrier (1a, 1b; T1, T2);
wherein the carrier (1a, 1b; T1) comprises at least one intervention opening (2, 2') adapted to provide an access for a medical instrument (9) to the patient,
wherein the MRT local coil apparatus (1) is adapted to be positioned such on the patient such that the at least one intervention opening (2, 2') is located in body longitudinal direction of the patient approximately at the same position as the prostate (102) and the pelvis minor, respectively, that an rectangle circumscribing the at least one intervention opening (2, 2') is located dorsal above the prostate (102) and/or the pelvis minor, and that the MRT local coil apparatus (1) comprises arrangement means (5C, 5D) for the medical instrument.

2. MRT local coil apparatus according to claim 1, wherein a higher number of antenna elements (K21 - K24) is arranged in a region located close to the organ to be examined, wherein optionally a higher number of antenna elements (K21 - K24) is arranged in a region located close to the center of the pelvis minor and/or located close to the lateral wall of the pelvis major.

3. MRT local coil apparatus according to claim 1 or 2, wherein the carrier (1a, 1b; T1, T2) is formed as a cuff that may be closed and opened.

4. MRT local coil apparatus (1) according to one of claims 1 to 3, wherein the intervention opening (2, 2') is adapted for receiving a reference element (6) having first alignment means and being visible in the MRT image.

5. MRT local coil apparatus (1) according to one of claims 1 to 4, wherein the intervention opening (2, 2') is limited by a frame (5, 5'), wherein at two juxtaposed sides of the frame (5, 5') inclined sliding surfaces (5a, 5b) are provided, wherein the sliding surfaces (5a, 5b) are inclined with respect an axis perpendicular to the intervention opening (2, 2') in the same direction.

6. MRT local coil apparatus (1) according to one of claims 1 to 5, comprising cross beam arrangement means (5c, 5d) provided for arranging a cross beam (7) movable in at least a first direction (Y) above the intervention opening (2, 2'), wherein optionally a slide (8a) movable in a second direction (X) is coupled with the cross beam (7).

7. MRT local coil apparatus (1) according to claim 6, wherein the medical instrument (9), such as a needle (9), can be located at the intervention opening (2), at the cross beam (7) and/or at the slide (8a).

8. MRT local coil apparatus (1) according to one of claims 6 or 7, wherein the cross beam, the slide (8), an instrument holder and/or the border portion of the intervention opening (2, 2') comprises second adjustment means (7e).

9. MRT local coil apparatus (1) according to one of claims 1 to 8, wherein at least one antenna element (K11) is located between two intervention openings (2, 2') and/or wherein the winding of an antenna element (K', K") is arranged around the intervention opening (A).

10. MRT local coil apparatus (1) according to one of claims 1 to 9, wherein the winding of the antenna elements (K11 - K202) is formed essentially rectangular and/or at least one antenna element (K11 to K202) is arranged rectangular or parallel to the edge of the intervention opening (2, 2').

11. MRT local coil apparatus (1) according to one of claims 1 to 10, wherein the carrier (1a, 1b) extends in the longitudinal direction (T1y) farther than in cross direction (T1x) and wherein at least one antenna element (K21, K22) is located in cross direction (T1x) of the carrier (1a, 1b) beside the intervention opening (2, 2') and wherein at least one antenna element (K11) is arranged in longitudinal direction (T1y) of the carrier (1a, 1b) beside the intervention opening (2, 2').

12. MRT local coil apparatus (1) according to claim 11, wherein at least three antenna elements (K12, K22) are arranged in cross direction (T1x) of the carrier (1, 1') beside the at least one intervention opening (2, 2').

13. MRT local coil apparatus (1) according to one of claims 1 to 12, wherein the carrier (1, 1') comprises a first carrier portion (T1) that is adapted to be arranged on a first side of a part of a body of the patient, and a second carrier portion (T2) adapted to be arranged at a second side of the part of the body, wherein the at least one intervention opening (2, 2') is formed in the first carrier portion (T1) and wherein both in the first carrier portion (T1) and in the second carrier portion (T2) antenna elements (K, K11 - K203) are arranged.

14. MRT local coil apparatus (1) according to claim 13, wherein the carrier portion comprising the intervention opening is adapted to be placed such that the natal cleft is positioned on a line approximately in the middle between the intervention openings (2, 2') or approximately in the middle of the intervention opening (2).

15. MRT local coil apparatus (1) according to claims 13 or 14, wherein the first carrier portion (T1) can be arranged in two different positions with respect to the second carrier portion (T2).

16. MRT local coil apparatus (1) according to one of claims 13 to 15, wherein the first carrier portion (T1) can be moved such with respect to the second carrier portion (T2) that the intervention opening (2) may be positioned in two different positions.

17. MRT local coil apparatus (1) according to one of claims 13 to 16, wherein the first carrier portion (T1) is movable with respect to the second carrier portion (T2) such that the intervention opening (2) can be arranged in two different positions in cross direction of the MRT local coil apparatus (1) and/or in longitudinal direction of the patient.

18. MRT local coil apparatus (1) according to one of claims 13 to 17, wherein the MRT local coil apparatus (1) can be arranged at the pelvis minor or the abdomen of the patient (100), wherein the first carrier portion (T1) is adapted to be arranged in the diagnosis position at the front region on the patient (100), and the second carrier portion (T2) is adapted to be positioned in the diagnosis position at the back of the patient, wherein the first carrier portion (T1) is adapted to be arranged in the intervention position on the back of the patient (100), and wherein the second carrier portion (T2) is adapted to be positioned in the intervention position at the front of the patient, and wherein the first carrier portion (T1) can be arranged such with respect to the second carrier portion (T2) that the intervention opening (2) may be arranged in two different positions in the longitudinal direction of the patient.
